# EUROPÄISCHE PATENTSCHRIFT

(11) **EP 0 996 957 B1**
(45) Veröffentlichungstag und Bekanntmachung des Hinweises auf die Patenterteilung: **04.09.2002**
(21) Anmeldenummer: 98934827.1
(22) Anmeldetag: 29.05.1998
(51) Int. Cl.: H01G 2/04, H05K 3/32

(54) **KONDENSATORANSCHLUSS, INSBESONDERE FÜR EINEN ELEKTROLYT-LEISTUNGSKONDENSATOR**
CAPACITOR CONNECTOR, ESPECIALLY FOR AN ELECTROLYTIC POWER CAPACITOR
CONNEXION DE CONDENSATEUR, NOTAMMENT POUR CONDENSATEUR DE PUISSANCE ELECTROLYTIQUE

(30) Priorität: 31.05.1997 DE 19722910
(43) Veröffentlichungstag der Anmeldung: 03.05.2000
(73) Patentinhaber: ROBERT BOSCH GMBH, 70442 Stuttgart (DE)
(72) Erfinder: LANDSGESELL, Jürgen, D-74076 Heilbronn (DE)
(86) Internationale Anmeldenummer: DE9801471
(87) Internationale Veröffentlichungsnummer: WO98054738

(56) Entgegenhaltungen:
- EP-A- 0 450 122
- DE-A- 1 915 780
- DE-A- 4 439 272

## Beschreibung

### Stand der Technik

Die Erfindung geht aus von einem Kondensatoranschluß, insbesondere für einen Elektrolyt-Leistungskondensator, mit dem der Kondensator mechanisch und elektrisch an einem Befestigungsteil bzw. an elektrische Leiter anschließbar ist, gemäß der im Oberbegriff des Anspruchs 1 definierten Gattung.

Bei Anschlüssen von Kondensatoren, insbesondere von Elektrolyt-Leistungskondensatoren sind bei den heutigen Bauformen die Kondensatoren mit zu verschraubenden oder zu verlötenden Anschlüssen versehen. Jeder Kondensator trägt also zumindest zwei den elektrischen Anschlußpolen zugeordnete Schraubanschlüsse oder Lötösenanschlüsse.

Es ist in der Praxis heute üblich, daß die elektrischen Verbindungen zu einer Kondensatorbank, die sich aus mehreren Kondensatoren zusammensetzt, und Halbleiter-Leistungsschaltern mittels einer Anschlußschiene, sogenannte Busschiene oder Busbar, hergestellt werden. Dabei wird die Busbar an die Kondensatoranschlüsse und die Anschlüsse der HalbleiterLeistungsschalter angeschraubt. Da die einzelnen Bauelemente aufgrund unterschiedlicher Toleranzen nicht gleich hoch sind, entstehen Zug- und/oder Druckkräfte. Diese sind schädlich, da die Bauelemente an ihren Anschlüssen nur mit kleinen Kräften belastet werden dürfen. Zur Erhöhung der Leistungsfähigkeit werden Kondensatoren an ihrem Becherboden an einen Kühlkörper mechanisch im wesentlichen starr verbunden und oft auch daran befestigt. Werden mehrere Kondensatoren auf einem gemeinsamen Kühlkörper zum Aufbau einer Kondensatorbank starr befestigt, treten die vorstehend erwähnten Schwierigkeiten mit den Toleranzen an den Kondensatoranschlüssen vermehrt auf. Im Übrigen ist darüber hinaus allgemein das Anbringen der Verschraubungen oder das Verlöten der Anschlüsse bei der Endmontage solcher Kondensatorbänke recht zeitaufwendig und damit kostenintensiv.

### Vorteile der Erfindung

Der erfindungsgemäß gestaltete Kondensatoranschluß mit den kennzeichnenden Merkmalen des Anspruchs 1 hat demgegenüber den Vorteil, daß durch die besondere Gestaltung der Anschlüsse am Kondensator die Grundlage für eine toleranzausgleichende und einfache Steckverbindung geschaffen ist, durch welche schädliche Kraftbelastungen an den Anschlüssen vermieden werden.

Gemäß der Erfindung ist prinzipiell zur Realisierung vorgesehen, daß der Kondensatoranschluß am Kondensator selbst als Kontaktbolzen mit längerer, im wesentlichen glatter Kontaktfläche ausgestaltet ist.

Durch die in den weiteren Ansprüchen niedergelegten Maßnahmen sind vorteilhafte Weiterbildungen und Verbesserungen des im Anspruch 1 angegebenen Kondensatoranschlusses möglich.

Gemäß einer besonders zweckmäßigen und vorteilhaften Ausgestaltung der Erfindung ist der Kontaktbolzen in Form eines im Querschnitt runden oder ovalen Zylinders oder eines rechteckförmigen Stutzens, insbesondere Vierkants, gestaltet.

Entsprechend einer vorteilhaften Weiterbildung der Erfindung ist der Kontaktbolzen an seiner dem Kondensator abgewandten Seite mit einer Verdickung versehen. Dadurch wird das Abrutschen des Kondensators aus seiner Steckverbindung noch wirkungsvoller verhindert.

Eine besonders zweckmäßige und vorteilhafte Ausgestaltung der Erfindung beinhaltet, daß das den Kontaktbolzen aufnehmende Teil aus einer Kontaktfeder besteht, welche den Kontaktbolzen bei gleichzeitiger mechanischer Fixierung und Befestigung zur Herstellung des elektrischen Kontakts aufnimmt. Die Kontaktfeder ist an einem Tragteil befestigt. Damit wird eine einfache und toleranzausgleichende Steckverbindung komplettiert.

In einer besonders vorteilhaften Ausgestaltung dieses Teils des Kondensatoranschlusses ist die Kontaktfeder ringförmig gestaltet und umschließt den Kontaktbolzen allseitig. Alternativ kann die Kontaktfeder, die einem Kontaktbolzen zugeordnet ist, aus mehreren Teilfedern bestehen, welche sektoral auf der Kontaktfläche des Kontaktbolzens zum Aufliegen kommen. Die Auswahl, welche Form am geeignetsten ist, wird von den Anforderungen der Anwendung entscheidend beeinflußt.

Entsprechend einer anderen vorteilhaften Ausgestaltung der Kontaktfeder ist vorgesehen, daß die Kontaktfeder bzw. die Teilfedern in Seitenansicht gesehen im Kontaktierungsbereich eine im wesentlichen leicht gebogene Form aufweisen, insbesondere C-förmig, gestaltet sind. Dadurch wird das Einstecken der Kontaktbolzen des Kondensators in die zugehörigen Kontaktfedern einerseits wesentlich erleichtert und andererseits eine zuverlässige elektrische Kontaktierung sichergestellt.

Entsprechend vorteilhafter Weiterbildungen der Erfindung sind die Kontaktfeder bzw. die sie bildenden Teilfedern, entsprechend den zugehörigen elektrischen Pole, auf unterschiedlichen Leiterteilen einer Anschlußschiene, insbesondere einer Busschiene, befestigt. Zweckmäßiger Weise können mit einer Anschlußschiene mehrere Kondensatoren befestigend angeschlossen werden.

In vorteilhafter Weise ermöglicht die Erfingung den toleranzausgleichenden Aufbau einer Kondensatorbank, die aus mehreren Kondensatoren besteht, deren Kondensatoranschluß gemäß der Erfindung gestaltet ist, und bei der die Kondensatoren an ihren Becherböden, insbesondere mittels Schellen- oder Schraubverbindung, mit einem gemeinsamen Kühlkörper im wesentlichen starr verbunden sind.

### Zeichnung

Die Erfindung ist anhand des in der Zeichnung dargestellten Ausführungsbeispiels in der nachfolgenden Beschreibung näher erläutert. Es zeigt:

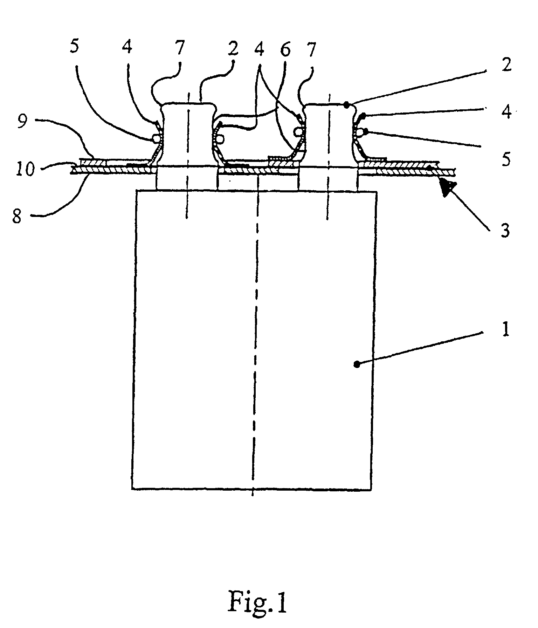

- Fig. 1: schematisch in Seitenansicht einen Kondensator mit den erfindungsgemäß gestalteten Kontaktbolzen sowie eine Anschlußschiene mit gemäß der Erfindung gestalteten Kontaktfedern.

### Beschreibung des Ausführungsbeispiels

In Fig. 1 ist schematisch in Seitenansicht ein Kondensator 1 mit den erfindungsgemäß gestalteten Kontaktbolzen 2 sowie ein Teil einer Anschlußschiene 3 mit gemäß der Erfindung gestalteten Kontaktfedern 4 dargestellt. Zur Erhöhung der Andruckkraft ist eine Zusatzfeder 5 vorgesehen, welche die Kontaktfeder 4 umgreifend umschließt, vorzugsweise in Form eines Ringes.

Jeder Kontaktbolzen 2 stellt den elektrischen Kontakt zum Kondensator je nach dem zugehörigen Pol her und dient daneben gleichzeitig gegebenenfalls der mechanischen Fixierung und Befestigung. Der Kontaktbolzen 2 ist bevorzugt in Form eines im Querschnitt runden oder ovalen Zylinders gestaltet, wie dies in Fig. 1 dargestellt ist. Er kann aber auch die Form eines rechteckförmigen Stutzens, insbesondere die eines Vierkants, aufweisen. Die den mechanischen und elektrischen Kontakt herstellende Kontaktfläche 6 des Kontaktbolzens 2 ist relativ lang, gesehen in Längsrichtung des Kontaktbolzens, und im wesentlichen glatt gestaltet. Dadurch wird eine verschiedene Toleranzen ausgleichende Gestaltung für fixierende Befestigung und elektrische Kontaktierung sichergestellt. Der Längenausgleich der Bauelemente ist also innerhalb der Kontaktierung.

Um eine weitere Sicherung und ein sicheres Einschnappen bei dem Einstecken zu erreichen, ist der Kontaktbolzen 2 an seiner dem Kondensator 1 abgewandten Seite mit einer Verdickung 7 versehen, die am äußeren Rand des Kontaktbolzens 2 als Wulst um diesen herum verläuft. Das Herausrutschen der Kontaktbolzen 2 aus den Kontaktfedern 4 wird dadurch wirkungsvoll erschwert.

Das den Kontaktbolzen 2 aufnehmende Teil besteht aus einer Kontaktfeder 4, welche den Kontaktbolzen 2 zur mechanisch fixierenden Befestigung und zur Herstellung des elektrischen Kontakts aufnimmt und welche an einem Tragteil, insbesondere an einer Anschlußschiene 3 befestigt ist. Diese Anschlußschiene 3 wird auch als Busschiene oder Busbar bezeichnet. Die Anschlußschiene 3 kann, wie im in der Fig. 1 dargestellten Ausführungsbeispiel gezeigt, aus zwei gegeneinander isolierten unterschiedlichen Leiterteilen 8 und 9 bestehen, welche, durch eine Isolierschicht 10 getrennt, den beiden elektrischen Polen zugeordnet sind. Die Kontaktfeder 4 wird entsprechend dem zugehörigen elektrischen Pol, entweder auf dem unteren Leiterteil 8 oder dem oberen Leiterteil 9 der Anschlußschiene 3, befestigt.

Die Kontaktfeder 4 kann auch aus sie bildenden Teilfedern bestehen, die den Kontaktbolzen 2 sektoral kontaktieren. Dieser Fall ist in der Fig. 1 nicht dargestellt. Diese Teilfedern werden auf dieselbe Weise an der Anschlußschiene 3 befestigt, wie die aus einem Stück bestehenden Kontaktfedern 4.

Die Anschlußschiene 3 kann so gestaltet sein, daß mehrere Kondensatoren auf ihr zur Bildung einer Kondensatorbank befestigt werden können. Die mechanische Verbindung zwischen den Kontaktfedern 4 mit den zugehörigen Leiterteilen 8 und 9 erfolgt beispielsweise durch Schweißen oder Löten.

Die Kontaktfeder 4 bzw. die Teilfedern weisen im Kontaktierungsbereich 6 in Seitenansicht gesehen eine im wesentlichen leicht gebogene Form auf, sie sind insbesondere C-förmig gestaltet. Dadurch wird das Einstecken der Kontaktbolzen 2 des Kondensators 1 in die zugehörigen Kontaktfedern 4 einerseits wesentlich erleichtert und andererseits wird eine zuverlässige elektrische Kontaktierung sichergestellt sowie eine sichere Befestigung erreicht.

Werden mehrere Kondensatoren 1 zu einer Kondensatorbank mittels der Busbar zusammengefaßt, elektrisch verbunden und gegebenenfalls mechanisch fixierend befestigt, können die Kondensatoren in bekannter Form mit Kühlkörpern versehen werden. Dazu werden beispielsweise die Becherböden der einzelnen Kondensatoren mittels Schellen oder Schraubverbindungen im wesentlichen starr auf Kühlkörpern, vorzugsweise einem gemeinsamen Kühlkörper, befestigt. Auf ihrer anderen Seite sind die Kondensatoren elektrisch und mechanisch fixiert über die Busbar miteinander verbunden. Eine solche Kondensatorbank kann auf derselben Busbar mit den Halbleiter-Leistungsschaltelementen in derselben Befestigungstechnik wie sie die Erfindung angibt oder auf herkömmliche Weise verbunden werden.

Die mit dem erfindungsgemäß gestalteten Kondensatoranschluß erzielten Vorteile liegen darin, daß bei der Montage keine Schraubverbindungen nötig sind, daß der Längenausgleich der Bauelemente innerhalb der Kontaktierung erfolgt, die unterschiedliche Längenausdehnung der Bauelemente durch den federnden Kontakt ausgeglichen wird, daß die durch unterschiedlich lange Bauelemente entstehenden Kräfte entfallen, wodurch in vorteilhafter Weise die Bauelementanschlüsse weniger belastet werden und daß schließlich dann, wenn der Kontaktbolzen bereits Bestandteil des Kondensatoranschlusses ist, nur die Kontaktfeder und gegebenenfalls die Zusatzfeder erforderlich sind. Dies kommt insbesondere dann zum Tragen, wenn mehrere Kondensatoren an ihrem Becherboden auf einem gemeinsamen Kühlkörper, beispielsweise mittels Verschraubung, zum Aufbau einer Kondensatorbank befestigt sind.

## Patentansprüche

1. Kondensatoranschluß, insbesondere für einen Elektrolyt-Leistungskondensator, mit dem der Kondensator (1) mechanisch und elektrisch an einem Befestigungsteil (3) bzw. an elektrische Leiter (8, 9) anschließbar ist,
**dadurch gekennzeichnet, daß**
der Kondensatoranschluß am Kondensator (1) selbst als Kontaktbolzen (2) mit längerer, im wesentlichen glatter Kontaktfläche (6) ausgestaltet ist.

2. Kondensatoranschluß nach Anspruch 1, **dadurch gekennzeichnet, daß** der Kontaktbolzen (2) in Form eines im Querschnitt runden oder ovalen Zylinders oder eines rechteckförmigen Stutzens, insbesondere Vierkants, gestaltet ist.

3. Kondensatoranschluß nach Anspruch 1 oder 2, **dadurch gekennzeichnet, daß** der Kontaktbolzen (2) an seiner dem Kondensator (1) abgewandten Seite mit einer Verdickung (7) versehen ist.

4. Kondensatoranschluß nach Anspruch 1, 2 oder 3, **dadurch gekennzeichnet, daß** das den Kontaktbolzen (2) aufnehmende Teil aus einer Kontaktfeder (4) besteht, welche den Kontaktbolzen (2), bei gleichzeitiger mechanischer Fixierung und Befestigung, zur Herstellung des elektrischen Kontakts aufnimmt und welche an einem Tragteil (3) befestigt ist.

5. Kondensatoranschluß nach Anspruch 4, **dadurch gekennzeichnet, daß** die Kontaktfeder (4) ringförmig gestaltet ist und den Kontaktbolzen (2) allseitig umschließt, oder daß die Kontaktfeder, die einem Kontaktbolzen zugeordnet ist, aus mehreren Teilfedern besteht, welche sektoral auf der Kontaktfläche (6) des Kontaktbolzens (2) zum Aufliegen kommt.

6. Kondensatoranschluß nach Anspruch 4 oder 5, **dadurch gekennzeichnet, daß** die Kontaktfeder (4) bzw. die Teilfedern in Seitenansicht im Kontaktierungsbereich eine im wesentlichen leicht gebogene Form aufweisen, insbesondere C-förmig gestaltet sind.

7. Kondensatoranschluß nach einem der Ansprüche 4 bis 6, **dadurch gekennzeichnet, daß** eine Zusatzfeder (5) vorgesehen ist, welche zur Erhöhung der Andruckkraft die Kontaktfeder (4) umgreifend umschließt, insbesondere ringförmig umschließt.

8. Kondensatoranschluß nach einem der Ansprüche 4 bis 7, **dadurch gekennzeichnet, daß** die Kontaktfeder (4) bzw. die sie bildenden Teilfedern, entsprechend der zugehörigen elektrischen Pole, auf unterschiedlichen Leiterteilen (8, 9) einer Anschlußschiene (3), insbesondere einer Busschiene, befestigt sind.

9. Kondensatoranschluß nach einem der Ansprüche 4 bis 8, **dadurch gekennzeichnet, daß** mit einer Anschlußschiene (3) mehrere Kondensatoren (1) befestigend anschließbar sind.

10. Kondensatorbank, bestehend aus mehreren Kondensatoren (1), deren Kondensatoranschluß (2, 4) gemäß einem der vorigen Ansprüche gestaltet ist, und die insbesondere mittels Schellen- oder Schraubverbindung mit einem gemeinsamen Kühlkörper im wesentlichen starr verbunden sind.

## Claims

1. Capacitor connection, in particular for an electrolytic power capacitor, by means of which the capacitor (1) can be mechanically and electrically connected to an attachment part (3) or to electrical conductors (8, 9),
**characterized in that**
the capacitor connection is formed on the capacitor (1) itself as a contact bolt (2) with a relatively long, essentially smooth contact surface (6).

2. Capacitor connection according to Claim 1, **characterized in that** the contact bolt (2) is in the form of a cylinder having a round or oval cross section, or in the form of a rectangular post, in particular a quadrilateral.

3. Capacitor connection according to Claim 1 or 2, **characterized in that** the contact bolt (2) has a thickened region (7) on its side facing away from the capacitor (1).

4. Capacitor connection according to Claim 1, 2 or 3, **characterized in that** the part which holds the contact bolt (2) consists of a contact spring (4) which holds the contact bolt (2), while at the same time providing mechanical fixing and attachment, in order to produce the electrical contact, and is attached to a supporting part (3).

5. Capacitor connection according to Claim 4, **characterized in that** the contact spring (4) has an annular shape and encloses the contact bolt (2) on all sides, or **in that** the contact spring, which is associated with a contact bolt, comprises a number of spring elements which come to rest in sector form on the contact surface (6) of the contact bolt (2).

6. Capacitor connection according to Claim 4 or 5, **characterized in that** the contact spring (4) or the spring elements have an essentially slightly curved shape, in particular a C-shape, in a side view of the contact-making area.

7. Capacitor connection according to one of Claims 4 to 6, **characterized in that** an additional spring (5) is provided, which encloses the contact spring (4), surrounding it, in particular enclosing it in an annular shape, in order to increase the contact force.

8. Capacitor connection according to one of Claims 4 to 7, **characterized in that** the contact spring (4) or the spring elements which form it are attached, corresponding to the associated electrical poles, to different conductor paths (8, 9) of a connecting rail (3), in particular a busbar.

9. Capacitor connection according to one of Claims 4 to 8, **characterized in that** a number of capacitors (1) can be connected, such that they are attached, by means of one connecting rail (3).

10. Capacitor bank, comprising a number of capacitors (1), whose capacitor connection (2, 4) is designed according to one of the preceding claims, and which are essentially rigidly connected to a common heat sink, in particular by means of a clamp or screw connection.

## Revendications

1. Connexion de condensateur, notamment d'un condensateur électrolytique de puissance, par lequel le condensateur (1) peut être connecté mécaniquement et électriquement à une pièce de fixation (3) ou à des conducteurs électriques (8, 9),
**caractérisée en ce que**
la connexion est réalisée directement sur le condensateur (1) comme goujon de contact (2) ayant une surface de contact (6), allongée, essentiellement lisse.

2. Connexion de condensateur selon la revendication 1,
**caractérisée en ce que**
le goujon de contact (2) se présente sous la forme d'un cylindre à section ronde ou ovale ou d'un embout à section rectangulaire notamment carrée.

3. Connexion de condensateur selon l'une des revendications 1 ou 2,
**caractérisée en ce que**
le goujon de contact (2) est muni d'un renforcement (6) à son extrémité opposée à celle du condensateur (1).

4. Connexion de condensateur selon l'une quelconque des revendications 1, 2 ou 3,
**caractérisée en ce que**
la partie recevant le goujon de contact (2) se compose d'un ressort de contact (4) qui reçoit le goujon de contact (2) pour réaliser le contact électrique, tout en le fixant et le bloquant mécaniquement, et ce ressort est fixé à une pièce de support (3).

5. Connexion de condensateur selon la revendication 4, **caractérisée en ce que**
le ressort de contact (4) a une forme annulaire et entoure de tous côtés le goujon de contact (2) ou
le ressort de contact est associé à un goujon de contact se composant de plusieurs parties de ressort venant en appui sur des secteurs de la surface de contact (6) du goujon de contact (2).

6. Connexion de condensateur selon l'une quelconque des revendicacations 4 ou 5,
**caracterisée en ce que**
le ressort de contact (4) ou les parties de ressort présentent en vue de côté, dans la zone de contact, une forme essentiellement légèrement cintrée, notamment une forme de C.

7. Connexion de condensateur selon l'une quelconque des revendications 4 à 6,
**caractérisée par**
un ressort complémentaire (5), notamment annulaire, qui entoure le ressort de contact (4) pour augmenter la force d'application.

8. Connexion de condensateur selon l'une quelconque des revendications 4 à 7,
**caractérisée en ce que**
le ressort de contact (4) ou les parties de ressort qui le constituent sont fixées en fonction des pôles électriques correspondants sur des pièces conductrices (8, 9) différentes d'un rail de branchement (9), notamment d'un bus.

9. Connexion de condensateur selon l'une quelconque des revendications 4 à 8,
**caractérisée en ce que**
plusieurs condensateurs (1) peuvent être reliés de manière à être fixés à un rail de branchement (3).

10. Ensemble de condensateurs formé de plusieurs condensateurs (1) dont les connexions (2, 4) sont réalisées selon l'une quelconque des revendications précédentes et qui sont notamment reliées d'une manière essentiellement rigide par une liaison à collier ou à vis à un organe de refroidissement commun.
